# EUROPÄISCHE PATENTSCHRIFT

(11) **EP 3 774 433 B1**
(45) Veröffentlichungstag und Bekanntmachung des Hinweises auf die Patenterteilung: **23.02.2022**
(21) Anmeldenummer: 19717785.0
(22) Anmeldetag: 04.04.2019
(51) Int. Cl.: B60K 37/06, H03K 17/96, H01H 1/48, H01H 3/12, H01H 1/34

(54) **BEDIENVORRICHTUNG FÜR EIN FAHRZEUG**
CONTROL DEVICE FOR A VEHICLE
DISPOSITIF DE COMMANDE POUR UN VÉHICULE

(30) Priorität: 13.04.2018 DE 102018108847
(43) Veröffentlichungstag der Anmeldung: 17.02.2021
(73) Patentinhaber: Behr-Hella Thermocontrol GmbH, 59557 Lippstadt (DE)
(72) Erfinder: LAMMINGER, Egbert, 59494 Soest (DE)
(74) Vertreter: dompatent von Kreisler Selting Werner - Partnerschaft von Patent- und Rechtsanwälten mbB
(86) Internationale Anmeldenummer: PCT/EP2019/058540
(87) Internationale Veröffentlichungsnummer: WO 2019/197273

(56) Entgegenhaltungen:
- WO-A1-2004/055846
- US-A1- 2008 316 064
- US-A1- 2012 044 660

## Beschreibung

Die Erfindung betrifft eine Bedienvorrichtung für ein Fahrzeug und insbesondere für eine Fahrzeugkomponente wie beispielsweise eine Klimaanlage, ein Navigationsgerät, ein Infotainmentsystem. Insbesondere betrifft die Erfindung ein Mensch-Maschine-Interface (HMI) für ein Fahrzeug.

Bedienvorrichtungen für Fahrzeuge sind entsprechend unterschiedlicher Bedienkonzepte konstruiert und ausgelegt. Bei Bedienvorrichtungen mit Bedientasten ist es mitunter wünschenswert, den Tastenhub so gering wie möglich zu halten (sogenannte Kurzhubtaster). Insbesondere ist man bestrebt, bei der Fertigung von Bedienvorrichtungen dafür zu sorgen, dass niederdrückbare Bedienelemente, wie z.B. Bedientasten oder auch niederdrückbare Displays mit Touchfunktion trotz gegebener Fertigungstoleranzen die geforderten, insbesondere identischen Hübe bis zum Erreichen der dem Bedienelement zugeordneten Schalterauslöseposition zurücklegen. Dies ist insbesondere bei Kurzhubtastern anspruchsvoll.

Bedienvorrichtungen, bei denen der Niederdrückhub der Bedienelemente einstellbar ist, sind in US-B-6 919 522, US-A-2008/0316064 und US-A-2012/ 0044660 beschrieben. Bei den Bedienvorrichtungen nach US-A-2008/0316064 und US-B 6 919 522 befinden sich an den Bedientasten Einstellschrauben zur Einstellung der Schaltwege.

Bei der Bedienvorrichtung nach US-A-2012/0044660 befindet sich ein einer Bedientaste zugeordneter Schalter auf einer flexiblen Leiterkarte, die mittels einer Einstellschraube in Richtung auf das Bedienelement bewegbar ist, um den Schaltweg einzustellen. Die bekannte Bedienvorrichtung weist ein Gehäuse mit einer Vorderwand mit mindestens einem Bedienelement auf, das ausgehend von einer Ruheposition zwecks Eingabe eines Befehls oder zwecks Aktivierung einer Funktion manuell betätigbar ist. Dem Bedienelement ist ein Schalter zugeordnet, der ein Schaltorgan aufweist, auf das das Bedienelement bei manueller Betätigung einwirkt. Im Gehäuse befindet sich im Abstand zum Bedienelement ein Trägerelement, an dem der dem Bedienelement zugeordnete Schalter angeordnet ist. Ferner weist die bekannte Bedienvorrichtung ein auf das Trägerelement einwirkendes Einstellorgan zur Einstellung der Position des Trägerelements relativ zum Bedienelement in dessen Ruheposition auf.

Aufgabe der Erfindung ist es, eine Bedienvorrichtung für ein Fahrzeug zu schaffen, deren Konstruktion die toleranzausgleichende Justage der Schalterauslöseposition erlaubt, und zwar auf einfach Art und Weise.

Zur Lösung dieser Aufgabe wird mit der Erfindung eine Bedienvorrichtung für ein Fahrzeug vorgeschlagen, die versehen ist mit
- einem Gehäuse mit einer Vorderwand,
- mindestens einem Bedienelement, das ausgehend von einer Ruheposition zwecks Eingabe eines Befehls oder zwecks Aktivierung einer Funktion manuell betätigbar ist,
- einem Schalter, der dem Bedienelement zugeordnet ist, mit einem Schaltorgan, auf das das Bedienelement bei manueller Betätigung einwirkt,
- einem im Gehäuse mit Abstand zum Bedienelement angeordneten Trägerelement,
- wobei das Trägerelement einen Biegebalken mit einer dem Bedienelement zugewandten Oberseite und einer der Oberseite abgewandten Unterseite aufweist und
- wobei der dem Bedienelement zugeordnete Schalter an dem Biegebalken angeordnet ist und
- einem auf den Biegebalken einwirkenden Einstellorgan zur Einstellung der Biegeposition des Biegebalkens relativ zum Bedienelement in dessen Ruheposition und zum Beibehalten und damit Stabilisieren des Biegebalkens in seiner eingestellten Biegeposition bei Einwirkung des Bedienelements auf das Schaltorgan.

Bei der erfindungsgemäßen Bedienvorrichtung lässt sich die Position des Schalters relativ zu diesem Schalter zugeordneten Bedienelement werkseitig verstellen. Typischerweise sind die den Bedienelementen zugeordneten Schalter auf einer Platine bzw. allgemein ausgedrückt an einem Trägerelement angeordnet, das sich hinter der Vorderwand des Gehäuses in diesem befindet. Auf der Platine sind neben elektrischen Leiterbahnen noch weitere elektrische und elektronische Bauteile angeordnet. Bei den Schaltern kann es sich beispielsweise um Kurzhubschalter oder aber eine auf einer Platine aufliegende Schaltmatte handeln. Auch sind kapazitiv, resistiv, induktiv oder optisch arbeitende Schalter in Form von Sensoren und insbesondere Wegsensoren einsetzbar.

Erfindungsgefäß befindet sich nun der einem Bedienelement zugeordnete Schalter auf einem Biegebalken des Trägerelements. Im Falle der Ausbildung des Trägerelements als Leiterplatine kann dieser Biegebalken als an drei Seiten freigeschnittener Steg ausgebildet sein, dessen eines Ende mit der Leiterplatine einstückig verbunden ist und dessen anderes Ende frei ist. Der Biegebalken kann aber auch als zusätzliches separates Bauteil am Trägerelement angeordnet sein, beispielsweise als Zunge o.dgl. Überstandselement. Auf den Biegebalken wirkt ein Einstellorgan ein, mit dem sich die Position des Biegebalkens verändern lässt. Auch dient das Einstellorgan der Stabilisierung der eingenommenen Biegeposition des Biegebalkens, wenn bei Betätigung des Bedienelements auf das Schaltorgan des Schalters eingewirkt wird und damit über das Schaltorgan oder den Schalter gegebenenfalls Druck auf den Biegebalken ausgeübt wird.

Die Feinjustage der gewünschten Schalterauslöseposition kann nun dergestalt erfolgen, dass bei fertig gestellter Bedienvorrichtung das einem Schalter bzw. einem Biegebalken zugeordnete Einstellorgan bei in seiner Ruheposition befindlichem Bedienelement verstellt wird, um den Biegebalken zu verbiegen, so dass der Schalter in Richtung Bedienelement vorbewegt wird. Dieser Vorgang wird so lange fortgesetzt, bis der Schalter bzw. das Schaltorgan des Schalters sich in seiner Schalterauslöseposition befindet. Durch anschließendes Zurückbewegen oder Zurückverstellen des Einstellorgans um ein vorgegebenes Maß kann nun der Biegebalken in eine Biegeposition überführt werden, in der sich dann der Schalter in einem Abstand zum Bedienelement befindet, der dem gewünschten Auslöseweg entspricht, um den das Bedienelement bei Betätigung niedergedrückt werden muss, bis das Schalterorgan die Schalterauslöseposition erreicht hat.

Bei dem Bedienelement handelt es sich typischerweise um ein Element mit mehreren Schaltflächen und einer Touch-Sensorik (kapazitiv, resistiv, optisch oder induktiv arbeitend). Zur Auslösung eines Befehls, der durch Berührung einer der Schaltflächen des Bedienelements eingegeben wird, dient also stets der eine Schalter.

Das Einstellorgan ist vorzugsweise an einem Referenzelement gelagert bzw. geführt, das eine bezüglich des Trägerelements und dem Bedienelement (in dessen Ruheposition) definierte und gleichbleibende Position aufweist. Das Einstellorgan kann beispielsweise eine Schraube, ein Keil, ein Exzenter oder eine Scheibe mit längs des Umfangsrandes ansteigendem Niveau sein.

Mit anderen Worten ist also, wie oben beschrieben, nach der Erfindung mit Vorteil vorgesehen, dass das Schaltorgan von dem Bedienelement längs eines Schaltwegs bis zu einer Schalterauslöseposition bewegbar ist und dass der Biegebalken mittels des Einstellorgans in eine Biegeposition überführbar und in dieser Biegeposition fixierbar ist, in der der Auslöseweg, um den das Bedienelement bis zum z.B. durch ein Schaltorgan erfolgenden Erreichen der Schalterauslöseposition bewegbar ist, unter Kompensation von Montage- und/oder Fertigungstoleranzen des Gehäuses des Bedienelements und des Schalters, eine vorgebbare Länge aufweist.

Das Einstellorgan ist zweckmäßigerweise als Einstellschraube mit Gewindeschaft ausgebildet, wodurch das Maß, um das das Einstellorgan, dann, wenn das Schaltorgan bei der Feinjustage des Schalters die Schalterauslöseposition erreicht hat, zurückbewegt wird, bei bekannter Gewindesteigung anhand des Ausmaßes der Verdrehung der Einstellschraube definiert ist und gezielt angefahren werden kann.

Bei Ausbildung des Einstellorgans als Einstellschraube mit einem Gewindeschaft, kann mit Vorteil vorgesehen sein, dass der Gewindeschaft mit dem relativ zum Biegebalken des Trägerelements positionierten Referenzelement in Gewindeeingriff steht. Damit kann sich dann durch Verdrehung der Einstellschraube deren Gewindeschaftende in Richtung Biegebalken vorbewegen und diesen verbiegen, wobei bei der Zurückbewegung der Biegebalken aufgrund seiner Elastizität wiederum der Position des Gewindeschaftendes der Einstellschraube folgt.

Alternativ zu dem zuvor Gesagten kann die Einstellschraube auch als "lose Schraube" an dem Referenzelement axial positioniert gehalten sein, wobei in diesem Fall der Gewindeschaft der Einstellschraube im Gewindeeingriff mit dem Biegebalken steht und diesen bidirektional verbiegen kann.

Um bei der Feinjustage des Schalters durch Verbiegen bzw. Zurückverbiegen des Biegebalkens nicht noch Hebelübersetzungsverhältnisse am Biegebalken berücksichtigen zu müssen, ist es von Vorteil, wenn das Einstellorgan auf den Biegebalken an einer Position einwirkt, die in Verlängerung der Bewegung des Schaltorgans bei dessen Betätigung durch das Bedienelement liegt. Bei einseitig am Biegebalken anliegendem Einstellorgan, das bei seiner Verstellung mehr oder weniger stark auf dem Biegebalken einwirkt, um diesen in Richtung Bedienelement zu verbiegen bzw. bei der Zurückbewegung den Biegebalken wieder zu entlasten, ist gemäß einer vorteilhaften Ausgestaltung der Erfindung vorgesehen, dass der Schalter auf der dem Bedienelement zugewandten Oberseite des Biegebalkens angeordnet ist und dass die Einstellschraube, an der der Oberseite abgewandten Unterseite des Biegebalkens und in Flucht mit dem Schalter anliegt.

Mit dem erfindungsgemäßen Konzept ist es möglich, Schaltersysteme im Verbund anzuordnen, so dass ein kurzes Ansprechen des Bedienelements mit Schaltwegen von bis zu kleiner als 0,4mm ermöglichst wird. Ferner können kleinste Betätigungswege (unter 0,3mm) umgesetzt werden. Die Toleranz des Schaltersystems in Verbund kann bis auf kleiner als +/- 0,1mm reduziert werden. Die Toleranzen der Einzelteile (Tastenkörper, Tastenführung am Gehäuse bzw. an der Frontblende, Schalter, Schaltorgan und deren Zusammenbau können kompensiert werden.

In weiterer vorteilhafter Ausgestaltung der Erfindung kann vorgesehen sein, dass die Bedienvorrichtung mit einem haptischen Feedback versehen ist. Es steigert den Bedienkomfort, wenn dem Anwender die Erkennung einer validen Bedienung des Bedienelements signalisiert wird. Dies erfolgt vor allem vorteilhafterweise durch eine taktile Rückmeldung. Ein derartiges haptisches Feedback lässt sich beispielsweise mechanisch, elektromechanisch oder aber auch elektrisch realisieren. Ein mechanisches taktiles Feedback lässt sich dadurch realisieren, dass das Display mittels eines Aktuators impulsartig mechanisch angeregt wird. Eine andere Möglichkeit der Realisierung eines haptischen Feedbacks besteht darin, dass in das Display bzw. in das Abdeckglas des Displays Biegewellen eingeprägt werden. Eine weitere Möglichkeit der Realisierung des haptischen Feedbacks besteht in einer rein elektrisch arbeitenden Variante mittels örtlich erzeugter elektrischer Felder.

Die Erfindung wird nachfolgend anhand eines Ausführungsbeispiels sowie unter Bezugnahme auf die Zeichnung näher erläutert. Im Einzelnen zeigen:
- Fig. 1: eine Vorderansicht (perspektivisch) auf eine Bedienvorrichtung,
- Fig. 2: einen Schnitt durch die Bedienvorrichtung gemäß II-II der Fig. 1,
- Fig. 3: eine Schnittansicht im Bereich III-III der Fig. 2 und
- Fign. 4 bis 6: die einzelnen Phasen bei der Feinjustage des Schaltersystems (bezogen auf ein Bedienelement).

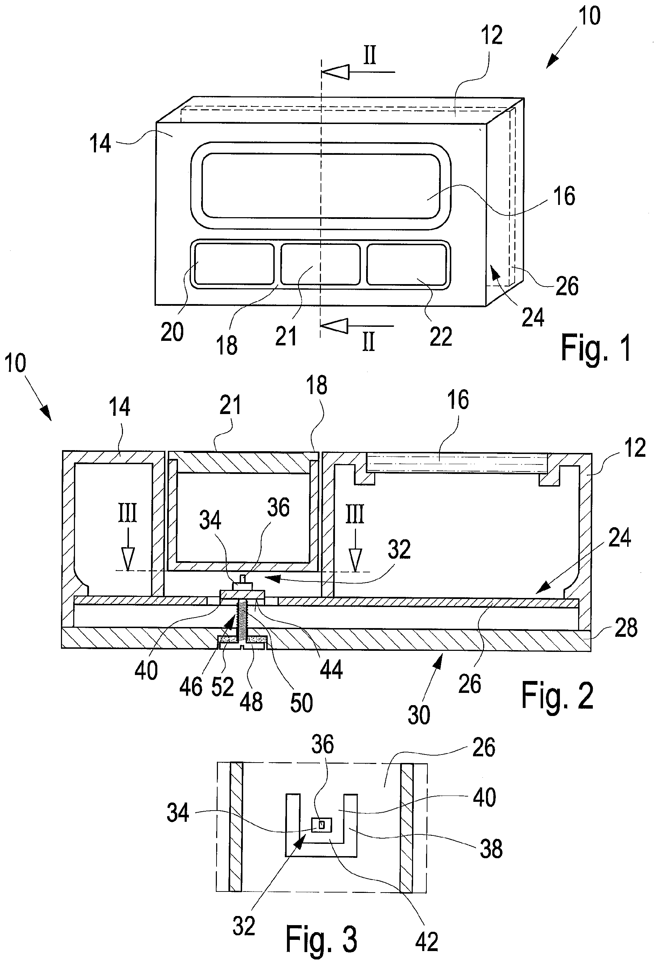

In den Fign. 1 bis 3 ist die grundsätzliche Konstruktion eines Ausführungsbeispiels einer Bedienvorrichtung 10 gezeigt. In diesem Ausführungsbeispiel weist die Bedienvorrichtung 10 ein Gehäuse 12 auf, an dessen Vorderwand 14 sich beispielsweise ein Display 16 sowie ein Bedienelement 18 in Form einer Leiste mit drei Bedienfeldern 20, 21, 22 befinden. Innerhalb des Gehäuses 12 befindet sich ein Trägerelement 24 für diverse elektrische und elektronische Komponenten. Bei diesem Trägerelement 24 handelt es sich typischerweise um eine Leiterplatine 26. Das Gehäuse 12 weist ferner eine Rückwand 28 auf, die in diesem Ausführungsbeispiel auch die Funktion eines Referenzelements 30 ausübt, worauf weiter unten noch eingegangen werden wird.

Gemäß den Schnittansichten der Fign. 2 und 3 befindet sich unterhalb des Bedienelements 18 ein in diesem Ausführungsbeispiel mechanischer Schalter 32, der ein Schaltergehäuse 34 und ein Schaltorgan 36 aufweist. Das Schaltorgan 36 ist in diesem Falle als Stößel ausgebildet, der beim Niederdrücken z.B. ein elektrisch leitendes Element zur elektrischen Verbindung zweier Kontaktfelder bewegt. Bei Betätigung des Bedienelements 18 wird sensorisch (z. B. kapazitiv) erkannt, welches der Bedienfelder 20, 21, 22 mit z. B. einem Finger einer Hand berührt wird, um dann beim Auslösen des Schalters 32 den dem berührten Bedienfeld entsprechenden Befehl auszuführen.

Der Schalter 32 befindet sich in einem Bereich des Trägerelements 24, in dem dieses einen beispielsweise U-förmigen Freischnitt 38 aufweist. Auf diese Weise entsteht ein Biegebalken 40, auf dessen dem Bedienelement 18 zugewandten Oberseite 42 sich der Schalter 32 befindet.

Auf die Unterseite 44 des Biegebalkens 40 wirkt ein Einstellorgan 46 ein, das in diesem Ausführungsbeispiel als Einstellschraube 48 mit Gewindeschaft 50 ausgebildet ist. Mit ihrem Gewindeschaft 50 ist die Einstellschraube 48 in Gewindeeingriff mit einer Bohrung in der Rückwand 28. Vorzugsweise wirkt das Gewindeschaftende der Einstellschraube 48 dem Schalter 32 gegenüberliegend auf die Unterseite des Biegebalkens 40 ein, indem es dort anliegt.

In Fig. 2 ist der Biegebalken 40 in Richtung Bedienelement 18 verbogen, so dass sich der Schalter 32 in der gewünschten Position relativ zur Ruheposition des Bedienelements 18 befindet. Diese Abstandsposition definiert, dass das Bedienelement 18 nach Niederdrücken um den gewünschten Weg den Schalter 32 auslöst. Das Bedienelement 18 ist in bekannter Weise durch z. B. Rast- oder Schnapphaken gegen eine Herausbewegung aus dem Gehäuse 12 gesichert.

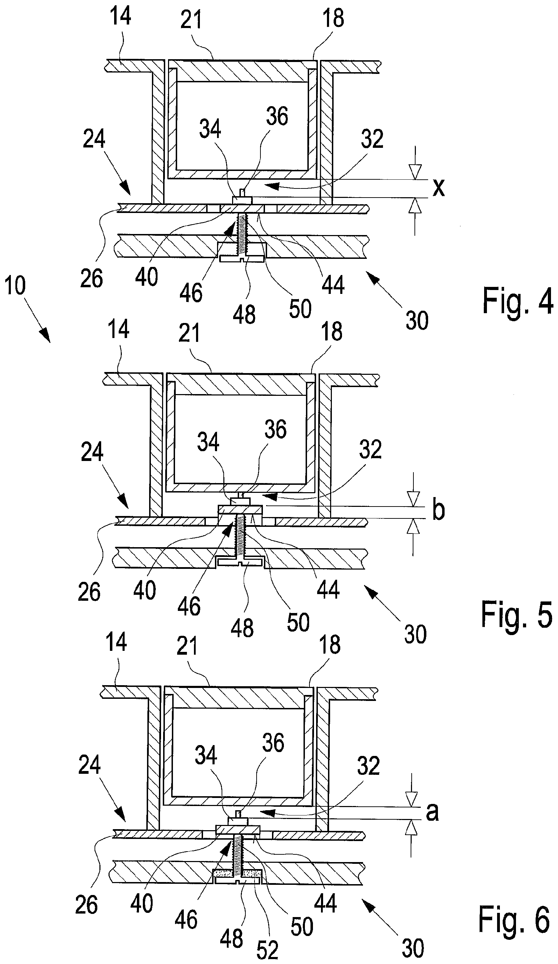

Die Vorgehensweise für die erfindungsgemäße Feinjustage des Schaltersystems aus Bedienelement 18 und zugeordnetem Schalter 32 wird nachfolgend anhand der Fign. 4 bis 6 kurz beschrieben.

Bei Beginn des Justagevorgangs hat der Schalter 32 (in diesem Fall das Schaltergehäuse 34) zur Unterseite des in Ruheposition befindlichen Bedienelements 18 den Abstand x (siehe Fig. 4), der größer ist als der gewünschte Auslöseweg a (siehe Fig. 6). Mittels der Einstellschraube 48 wird nun der Biegebalken 40 in Richtung Bedienelement 18 verbogen, wodurch der Schalter 32 gegen die Unterseite des Bedienelements 18 bewegt wird. Nach dem Zurücklegen des Verstell-bzw. Verbiegeweges b löst der Schalter 32 aus (siehe Fig. 5). Das Schaltsignal wird z.B. über eine Geräte-Test-Schnittstelle am Ende der Montage der Bedienvorrichtung 10 eingelesen, wodurch die weitere Betätigung der Einstellschraube 48, was beispielsweise automatisch erfolgt, beendet wird. Nun ist bekannt, wann der Schalter 32 auslöst.

In dieser Situation ist das Schaltersystem im geschalteten Zustand und ohne Spiel in der Bedienvorrichtung angeordnet. Anzumerken ist dabei, dass der Schalter 32 nicht auf Blockmaß zusammengefahren sein sollte; dies dient dem mechanischen Schutz des Schalters 32.

Mit anderen Worten ist also dann, wenn die Situation gemäß Fig. 5 vorliegt, bekannt, wo der Schaltpunkt (spielfrei) des Schalters 32 im System liegt.

Im Umkehrschluss lässt sich nun mit einer gezielten Rückstellung der Einstellschraube 48 spielfrei ein genauer Schaltweg (Auslöseweg) des Schaltersystems einstellen. Mit dieser Zurückstellung der Einstellschraube 48 durch deren Zurückverdrehen wird der Schalter 32 in seine Endposition gebracht, in der beim Niederdrücken des Bedienelements 18 das Schaltorgan 36 des Schalters 32 bis in die Schalterauslöseposition und damit das Bedienelement 18 um den Auslöseweg a bewegt ist (siehe Fig. 6).

Das Einstellorgan 46, d. h. in diesem Ausführungsbeispiel die Einstellschraube 48, kann danach fixiert werden, was z. B. durch Verkleben des Schraubenkopfes erfolgt, wie bei 52 angedeutet. Im Weiteren stabilisiert also das Einstellorgan 46 den Biegebalken 40 in dessen nach der Justage eingenommenen Biegeposition.

Mit dem zuvor beschriebenen Verfahren und der zuvor Bedienvorrichtungskonstruktion bzw. dem Schaltersystem aus Bedienelement 18 und Schalter 32 sowie Biegebalken 40 ist es möglich, die Toleranzkette dieses mechanischen "Verbundsystems" auf null zu reduzieren. Es können kleine Schaltwege trotz hoher Bauteiltoleranzen und große Toleranzketten im Verbund ausgeglichen werden.

## Patentansprüche

1. Bedienvorrichtung (10) für ein Fahrzeug, mit
- einem Gehäuse (12) mit einer Vorderwand (14),
- mindestens einem Bedienelement (18), das ausgehend von einer Ruheposition zwecks Eingabe eines Befehls oder zwecks Aktivierung einer Funktion manuell betätigbar ist,
- einem Schalter (32), der dem Bedienelement (18) zugeordnet ist, mit einem Schaltorgan (36), auf das das Bedienelement (18) bei manueller Betätigung einwirkt,
- einem im Gehäuse (12) mit Abstand zum Bedienelement (18) angeordneten Trägerelement (24),
- wobei das Trägerelement (24) einen Biegebalken (40) mit einer dem Bedienelement (18) zugewandten Oberseite (42) und einer der Oberseite (42) abgewandten Unterseite (44) aufweist,
- wobei der dem Bedienelement (18) zugeordnete Schalter (32) an dem Biegebalken (40) angeordnet ist, und
- einem auf den Biegebalken (40) einwirkenden Einstellorgan (46) zur Einstellung der Biegeposition des Biegebalkens (40) relativ zum Bedienelement (18) in dessen Ruheposition und zum Beibehalten und damit zum Stabilisieren des Biegebalkens (40) in seiner eingestellten Biegeposition bei Einwirkung des Bedienelements (18) auf das Schaltorgan.

2. Bedienvorrichtung (10) nach Anspruch 1, **dadurch gekennzeichnet, dass** der Schalter (32) ein von dem Bedienelement (18) längs eines Schaltwegs bis zu einer Schalterauslöseposition bewegbares Schaltorgan (36) aufweist und dass der Biegebalken (40) mittels des Einstellorgans (46) in eine Biegeposition überführbar und in dieser Biegeposition fixierbar ist, in der der Schaltweg eine vorgebbare Länge aufweist, und zwar unter Kompensation von Montage- und/oder Fertigungstoleranzen des Gehäuses (12), des Bedienelements (18) und des Schalters (32).

3. Bedienvorrichtung (10) nach Anspruch 1 oder 2, **dadurch gekennzeichnet, dass** das Einstellorgan (46) als eine Einstellschraube (48) mit einem Gewindeschaft (50) ausgebildet ist, die mit einem relativ zu dem Biegebalken (40) des Trägerelements (24) positionierten Referenzelement (30) in Gewindeeingriff steht, und dass durch Verdrehung der Einstellschraube (48) der Biegebalken (40) verbiegbar ist.

4. Bedienvorrichtung (10) nach Anspruch 1 oder 2, **dadurch gekennzeichnet, dass** das Einstellorgan (46) als eine Einstellschraube (48) mit einem Gewindeschaft (50) ausgebildet ist, die an einem relativ zum Biegebalken (40) des Trägerelements (24) positionierten Referenzelement (30) drehbar und axial gehalten ist, dass der Gewindeschaft (50) der Einstellschraube (48) mit dem Biegebalken (40) in Gewindeeingriff steht und dass bei Verdrehung der Einstellschraube (48) der Biegebalken (40) verbiegbar ist.

5. Bedienvorrichtung (10) nach einem der vorhergehenden Ansprüche, **dadurch gekennzeichnet, dass** der Schalter (32) mindestens zwei in einer Schalterauslöseposition elektrisch verbundene Kontakte aufweist oder dass der Schalter (32) als Wegsensor ausgebildet ist, der optisch, kapazitiv, resistiv oder induktiv arbeitet.

6. Bedienvorrichtung (10) nach einem der Ansprüche 1 bis 5, **dadurch gekennzeichnet, dass** das Einstellorgan (46) auf den Biegebalken (40) an einer Position einwirkt, die in Verlängerung der durch den Schalter (32) verlaufenden Bewegungsachse des Bedienelements (18) des Schaltorgans bei dessen Betätigung liegt.

7. Bedienvorrichtung (10) nach einem der Ansprüche 1 bis 6, **dadurch gekennzeichnet, dass** der Schalter (32) auf der dem Bedienelement (18) zugewandten Oberseite (42) des Biegebalkens (40) angeordnet ist und dass die Einstellschraube (48), an der der Oberseite (42) abgewandten Unterseite (44) des Biegebalkens (40) und in Flucht mit dem Schalter (32) anliegt.

8. Bedienvorrichtung nach einem der Ansprüche 1 bis 7, **gekennzeichnet durch** eine elektrisch oder elektromechanisch oder elektromagnetisch arbeitende Rückmeldeeinheit zur taktilen Rückmeldung einer validen manuellen Betätigung des Bedienelements (18).

## Claims

1. An operating device (10) for a vehicle, comprising
- a housing (12) having a front wall (14),
- at least one operating element (18) which, starting from a resting position, is adapted to be manually actuated for inputting a command or for activating a function,
- a switch (32) associated with the operating element (18) and having a switching member (36) upon which the operating element (18) acts when being manually actuated,
- a supporting element (24) arranged in the housing (12) at a distance to the operating element (18),
- wherein the supporting element (24) comprises a flexible bar (40) having an upper side (42) facing the operating element (18) and a lower side (44) facing away from the upper side (42),
- wherein the switch (32) associated with the operating element (18) is arranged at the flexible bar (40), and
- an adjustment member (46) acting upon the flexible bar (40) for adjusting the bending position of the flexible bar (40) relative to the operating element (18) in its resting position and for keeping and thus stabilizing the flexible bar (40) in its adjusted bending position when the operating element (18) acts upon the switching member.

2. The operating device (10) according to claim 1, **characterized in that** the switch (32) comprises a switching member (36) adapted to be moved by the operating element (18) along a switching path up to a switch triggering position, and that the flexible bar (40) is adapted to be both displaced into a bending position by means of the adjustment member (46) and fixed in said bending position, wherein, in the bending position, the switching path has a presettable length, in consideration of compensation of manufacturing and/or of assembly tolerances of the housing (12), of the operating element (18) and of the switch (32).

3. The operating device (10) according to claim 1 or 2, **characterized in that** the adjustment member (46) is configured as an adjustment screw (48) having a threaded shaft (50) and which is in threading engagement with a reference element (30) positioned relative to the flexible bar (40) of the supporting element (24), and that by turning the adjustment screw (48) the flexible bar (40) is adapted to be bent.

4. The operating device (10) according to claim 1 or 2, **characterized in that** the adjustment member (46) is configured as an adjustment screw (48) having a threaded shaft (50) and which is axially held in a turnable manner at a reference element (30) positioned relative to the flexible bar (40) of the supporting element (24), that the threaded shaft (50) of the adjustment screw (48) is in threading engagement with the flexible bar (40), and that, when the adjustment screw (48) is turned, the flexible bar (40) is adapted to be bent.

5. The operating device (10) according to any one of the preceding claims, **characterized in that** the switch (32) comprises at least two contacts electrically connected in a switch triggering position, or that the switch (32) is configured as a path sensor which operates in an optical, capacitive, resistive or inductive manner.

6. The operating device (10) according to any one of claims 1 to 5, **characterized in that** the adjustment member (46) acts upon the flexible bar (40) at a position arranged in alignment with the extension of the moving axis, extending through the switch (32), of the operating element (18) of the switching member when the latter is actuated.

7. The operating device (10) according to any one of claims 1 to 6, **characterized in that** the switch (32) is arranged on the upper side (42) of the flexible bar (40) facing the operating element (18), and that the adjustment screw (48) rests upon the lower side (44) of the flexible bar (40) facing away from the upper side (42) and in alignment with the switch (32).

8. The operating device according to any one of claims 1 to 7, **characterized by** an electrically or electromechanically or electromagnetically operating feedback unit for a tactile feedback of a valid manual actuation of the operating element (18).

## Revendications

1. Dispositif de commande (10) pour un véhicule, doté
- d'un boîtier (12) doté d'une paroi avant (14),
- d'au moins un élément de commande (18), lequel est actionnable manuellement à partir d'une position de repos afin de saisir un ordre ou afin d'activer une fonction,
- d'un commutateur (32), lequel est associé à l'élément de commande (18), doté d'un organe de commutation (36) sur lequel agit l'élément de commande (18) lors d'un actionnement manuel,
- d'un élément porteur (24) disposé dans le boîtier (12), à distance de l'élément de commande (18),
- dans lequel l'élément porteur (24) comporte une poutre de flexion (40) dotée d'une face supérieure (42) tournée vers l'élément de commande (18) et d'une face inférieure (44) se détournant de la face supérieure (42),
- dans lequel le commutateur (32) associé à l'élément de commande (18) est disposé sur la poutre de flexion (40), et
- d'un organe de réglage (46) opérant sur la poutre de flexion (40), destiné à régler la position de flexion de la poutre de flexion (40) par rapport à l'élément de commande (18) dans la position de repos de ce dernier et destiné à maintenir et ainsi à stabiliser la poutre de flexion (40) dans sa position de flexion lorsque l'élément de commande (18) opère sur l'organe de commutation.

2. Dispositif de commande (10) selon la revendication 1, **caractérisé en ce que** le commutateur (32) comporte un organe de commutation (36) pouvant être déplacé par l'élément de commande (18) le long d'un chemin de commutation jusqu'à une position de déclenchement du commutateur et **en ce que** la poutre de flexion (40) peut, au moyen de l'organe de réglage (46), être amenée dans une position de flexion et être fixée dans cette position de flexion où le chemin de commutation comporte une longueur prédéfinissable, et ceci en compensant pour les tolérances de montage et/ou de fabrication du boîtier (12), de l'élément de commande (18) et du commutateur (32).

3. Dispositif de commande (10) selon la revendication 1 ou 2, **caractérisé en ce que** l'organe de réglage (46) est réalisé comme vis de réglage (48) dotée d'une tige filetée (50), laquelle est en prise de filetage avec un élément de référence (30) positionné relativement à la poutre de flexion (40) de l'élément porteur (24), et **en ce que** la poutre de flexion (40) peut être fléchie par rotation de la vis de réglage (48).

4. Dispositif de commande (10) selon la revendication 1 ou 2, **caractérisé en ce que** l'organe de réglage (46) est réalisé comme vis de réglage (48) dotée d'une tige filetée (50), laquelle est en rotation sur un élément de référence (30) positionné relativement à la poutre de flexion (40) de l'élément porteur (24) et axialement maintenue, **en ce que** la tige filetée (50) de la vis de réglage (48) est en prise de filetage avec la poutre de flexion (40) et **en ce que** la poutre de flexion (40) peut être fléchie lors de la rotation de la vis de réglage (48).

5. Dispositif de commande (10) selon l'une des revendications précédentes, **caractérisé en ce que** le commutateur (32) comporte au moins deux contacts reliés électriquement dans une position de déclenchement du commutateur ou **en ce que** le commutateur (32) est réalisé comme capteur de mouvement à fonctionnement optique, capacitif, résistif ou inductif.

6. Dispositif de commande (10) selon l'une des revendications 1 à 5, **caractérisé en ce que** l'organe de réglage (46) opère sur la poutre de flexion (40) à une position se trouvant dans l'extension de l'axe de déplacement, passant à travers le commutateur (32), de l'élément de commande (18) de l'organe de commutation lors de l'actionnement de celui-ci.

7. Dispositif de commande (10) selon l'une des revendications 1 à 6, **caractérisé en ce que** le commutateur (32) est disposé sur la face supérieure (42), tournée vers l'élément de commande (18), de la poutre de flexion (40) et **en ce que** la vis de réglage (48) appuie sur la face inférieure (44), se détournant de la face supérieure (42), de la poutre de flexion (40) et en alignement par rapport au commutateur (32).

8. Dispositif de commande selon l'une des revendications 1 à 7, **caractérisé par** une unité de rétroaction fonctionnant de manière électrique ou électromécanique ou électromagnétique destinée à la rétroaction tactile d'un actionnement manuel valide de l'élément de commande (18).
